# EUROPÄISCHE PATENTSCHRIFT

(11) **EP 3 863 908 B1**
(45) Veröffentlichungstag und Bekanntmachung des Hinweises auf die Patenterteilung: **08.05.2024**
(21) Anmeldenummer: 19783301.5
(22) Anmeldetag: 04.10.2019
(51) Int. Cl.: B62D 5/04

(54) **REDUNDANTE STEUEREINHEIT FÜR EINE KRAFTFAHRZEUGLENKUNG**
REDUNDANT CONTROL UNIT FOR A MOTOR VEHICLE STEERING SYSTEM
UNITÉ DE COMMANDE REDONDANTE POUR DIRECTION DE VÉHICULE AUTOMOBILE

(30) Priorität: 09.10.2018 DE 102018124906
(43) Veröffentlichungstag der Anmeldung: 18.08.2021
(73) Patentinhaber: thyssenkrupp Presta AG, 9492 Eschen (LI); thyssenkrupp AG, 45143 Essen (DE)
(72) Erfinder: FEDERER, Tamas, 1148 Budapest (HU); NAGY, Attila, 2330 Dunaharaszti (HU); SZALAI, Peter, 1118 Budapest (HU)
(74) Vertreter: thyssenkrupp Intellectual Property GmbH
(86) Internationale Anmeldenummer: PCT/EP2019/076906
(87) Internationale Veröffentlichungsnummer: WO 2020/074386

(56) Entgegenhaltungen:
- EP-A1- 3 219 579
- EP-A1- 3 242 393
- JP-U- H0 520 976
- US-A1- 2002 177 932

## Beschreibung

Die vorliegende Erfindung betrifft eine Kraftfahrzeuglenkung mit den Merkmalen des Oberbegriffs des Anspruchs 1 und ein Verfahren zur Ansteuerung eines Elektromotors einer Kraftfahrzeuglenkung mit den Merkmalen des Oberbegriffs des Anspruchs 10.

Elektromechanische Lenkungen weisen Servomotoren zur Lenkunterstützung auf. Bei einem Kurzschluss in der Motorsteuerung wird herkömmlicherweise der Fehler erkannt, er kann sich aber ungehindert aufgrund des plötzlichen Spannungsausfalls ausbreiten. Dies ist unerwünscht. Aus der EP 3 219 579 A1 ist bereits bekannt, für die Ansteuerung eines Motors zwei Steuerpfade vorzusehen, wobei in dem Fall, dass eine Unregelmäßigkeit in Bezug auf einen Stromfluss in einem der Steuerpfade auftritt, der von der Unregelmäßigkeit betroffene Steuerpfad aufgetrennt wird.

Es ist Aufgabe der vorliegenden Erfindung eine Kraftfahrzeuglenkung anzugeben, die eine Schutzvorrichtung aufweist, die ein Ausbreiten eines Spannungsausfalls in der Motorsteuerung verhindert.

Diese Aufgabe wird von einer Kraftfahrzeuglenkung mit den Merkmalen des Anspruchs 1 und von einem Verfahren zur Ansteuerung eines Elektromotors einer Kraftfahrzeuglenkung mit den Merkmalen des Anspruchs 10 gelöst. In den Unteransprüchen sind vorteilhafte Weiterbildungen der Erfindung genannt.

Demnach ist eine Kraftfahrzeuglenkung umfassend einen Elektromotor zur Unterstützung der Lenkbewegung, und eine Steuereinheit, die den Elektromotor ansteuert, vorgesehen, wobei die Steuereinheit mindestens zwei redundante Steuerpfade zur Ansteuerung des Elektromotors und eine Unsymmetrieerkennungseinrichtung aufweist, wobei die Unsymmetrieerkennungseinrichtung dazu eingerichtet ist, die elektrischen Stromstärken beider Steuerpfade zu vergleichen und bei Vorliegen einer Unsymmetrie eine Auftrennung des fehlerhaften Steuerpfades zu bewirken. Es kann so verhindert werden, dass sich ein Fehler ausbreitet und die Steuereinheit funktionsunfähig wird. Das Vorliegen von zwei redundanten Steuerpfaden zur Ansteuerung des Elektromotors, umfasst dass, der Elektromotor über beide Steuerpfade jeweils, getrennt voneinander, angesteuert werden kann. Es kann aber auch vorgesehen sein, dass der Elektromotor mehrere Spulensätze beinhaltet oder aus mehreren getrennten Motoren besteht, deren Drehachsen mechanisch gekoppelt sind. In diesen Fällen ist jeweils ein Steuerpfad zur Ansteuerung eines Spulensatzes bzw. eines Motors vorgesehen.

Bevorzugt weist jeder Steuerpfad wenigstens ein Schaltelement auf, das mit der Unsymmetrieerkennungseinrichtung zur Auftrennung der Steuerpfade verbunden ist.

Vorzugsweise weist jeder Steuerpfad eine Strommessvorrichtung auf, die die elektrische Stromstärke separat für jeden Steuerpfad einzeln misst.

Ist vorteilhaft, wenn jeder Steuerpfad einen Inverter umfasst, wobei die Strommessvorrichtung in Signalrichtung vor dem Inverter angeordnet ist.

In einer vorteilhaften Ausführungsform weist jeder Steuerpfad eine eigene Stromquelle auf um die Redundanz weiter zu erhöhen.

Vorzugsweise weist jeder Steuerpfad eine eigene Schnittstelle zu einer Motorkontrolleinheit des Elektromotors auf.

In einer bevorzugten Ausführungsform weist die Unsymmetrieerkennungseinrichtung einen Operationsverstärker auf.

Erfindungsgemäß ist zudem vorgesehen, dass die Unsymmetrieerkennungseinrichtung für jeden Steuerpfad einen selbsthaltenden Komparator aufweist, der dazu eingerichtet ist, das Signal mit einer voreingestellten Referenzspannung zu vergleichen und auf Grundlage dieses Spannungsvergleichs ein Ausgangssignal zu erzeugen.

In einer vorteilhaften Ausführungsform ist die Kraftfahrzeuglenkung eine elektromechanische Kraftfahrzeugservolenkung, umfassend eine mit einem Lenkmittel verbundene obere Lenkwelle und eine mit der oberen Lenkwelle über einen Drehstab verbundene untere Lenkwelle, eine Drehmomentsensoreinheit, die ein von dem Fahrer in die obere Lenkwelle eingeleitetes Drehmoment einer Lenkbewegung erfasst, den Elektromotor zur Unterstützung der Lenkbewegung, und die zuvor beschriebene Steuereinheit, die dazu eingerichtet ist, in Abhängigkeit von dem gemessenen Drehmoment den Elektromotor anzusteuern. Vorzugsweise ist das Lenkmittel ein Lenkrad oder ein Joystick.

Es kann aber auch vorgesehen sein, dass die Kraftfahrzeuglenkung eine Steer-by-Wire-Lenkung ist, umfassend einen auf die gelenkten Räder wirkenden, in Abhängigkeit von einem Fahrerlenkwunsch elektronisch geregelten Lenksteller, der mittels eines Lenkgetriebes auf die gelenkten Räder wirkt, und einen Rückwirkungen der Straße auf ein Lenkrad übertragenden Feedback-Aktuator aufweisend den Elektromotor und die zuvor beschriebene Steuereinheit.

Weiterhin ist ein Verfahren zur Ansteuerung eines Elektromotors einer Kraftfahrzeuglenkung aufweisend eine Steuereinheit umfassend mindestens zwei redundanten Steuerpfade und eine Unsymmetrieerkennungseinrichtung vorgesehen, wobei jeder Steuerpfad wenigstens ein Schaltelement und eine Strommessvorrichtung aufweist, und wobei folgende Verfahrensschritte vorgesehen sind:
- Messen der jeweiligen elektrischen Stromstärke in den beiden Strom messvorrichtungen,
- Vergleichen der gemessenen elektrischen Stromstärken mittels der Unsymmetrieerkennungseinrichtung,
- Falls der Differenzwert der beiden elektrischen Stromstärken einen vorgegeben Grenzwert überschreitet, Auftrennen der Stromversorgung des fehlerhaften Steuerpfades mittels des wenigstens einen Schaltelementes,
- Ansteuern des Elektromotors mittels des fehlerfreien Steuerpfades.

Vorzugsweise umfasst jeder Steuerpfad einen Inverter, wobei das Strommessgerät in Signalrichtung vor dem Inverter angeordnet ist.

Um die Redundanz weiter zu erhöhen kann jeder Steuerpfad eine eigene Stromquelle aufweisen.

Vorzugsweise weist jeder Steuerpfad eine eigene Schnittstelle zu einer Motorkontrolleinheit des Elektromotors auf.

In einer bevorzugten Ausführungsform weist die Unsymmetrieerkennungseinrichtung einen Operationsverstärker auf.

Erfindungsgemäß ist zudem vorgesehen sein, dass die Unsymmetrieerkennungseinrichtung für jeden Steuerpfad einen selbsthaltenden Komparator aufweist, der dazu eingerichtet ist, das Signal mit einer voreingestellten Referenzspannung zu vergleichen und auf Grundlage dieses Spannungsvergleichs ein Ausgangssignal zu erzeugen.

Bei der erfindungsgemäßen Ausführungsform wird bei Vorliegen eines fehlerhaften Steuerpfades, für eine kurze Zeit der Komparator des fehlerfreien Steuerpfades deaktiviert, dadurch kann eine fehlerhafte Fehlerdetektion in dem fehlerfreien Steuerpfad verhindert werden.

Das Verfahren kann ebenfalls, wie oben beschrieben, sowohl in elektromechanischen Servolenkungen als auch in Steer-by-Wire-Lenkungen zum Einsatz kommen.

Eine bevorzugte Ausführungsform der Erfindung wird nachfolgend anhand der Zeichnungen näher erläutert. Gleiche bzw. funktionsgleiche Bauteile sind dabei figurübergreifend mit denselben Bezugszeichen versehen. Es zeigen:
- Figur 1:: eine schematische Darstellung einer elektromechanischen Servolenkung, sowie
- Figur 2:: ein Blockdiagramm einer Schutzvorrichtung für eine Motorsteuerung.

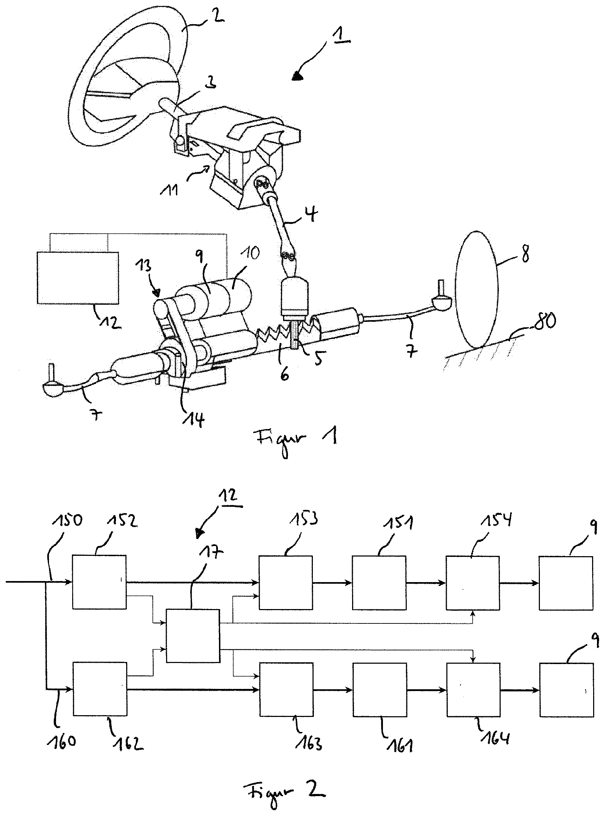

In der Figur 1 ist eine elektromechanische Kraftfahrzeugservolenkung 1 mit einem als Lenkrad ausgebildetem Lenkmittel 2, das mit einer oberen Lenkwelle 3 drehfest gekoppelt ist, schematisch dargestellt. Über das Lenkrad 2 bringt der Fahrer ein entsprechendes Drehmoment als Lenkbefehl in die obere Lenkwelle 3 ein. Das Drehmoment wird dann über die obere Lenkwelle 3 und untere Lenkwelle 4 auf ein Lenkritzel 5 übertragen. Das Ritzel 5 kämmt in bekannter Weise mit einem Zahnsegment einer Zahnstange 6. Die Zahnstange 6 ist in einem Lenkungsgehäuse in Richtung ihrer Längsachse verschieblich gelagert. An ihrem freien Ende ist die Zahnstange 6 mit Spurstangen 7 über nicht dargestellte Kugelgelenke verbunden. Die Spurstangen 7 selbst sind in bekannter Weise über Achsschenkel mit je einem gelenkten Rad 8 des Kraftfahrzeugs verbunden. Eine Drehung des Lenkrades 2 führt über die Verbindung der Lenkwelle 3 und des Ritzels 5 zu einer Längsverschiebung der Zahnstange 6 und damit zu einer Verschwenkung der gelenkten Räder 8. Die gelenkten Räder 8 erfahren über eine Fahrbahn 80 eine Rückwirkung, die der Lenkbewegung entgegen wirkt. Zum Verschwenken der Räder 8 ist folglich eine Kraft erforderlich, die ein entsprechendes Drehmoment am Lenkrad 2 erforderlich macht. Ein Elektromotor 9 einer Servoeinheit 10 ist vorgesehen, um den Fahrer bei dieser Lenkbewegung zu unterstützen. Die obere Lenkwelle 3 und die untere Lenkwelle 4 sind drehelastisch über einen nicht gezeigten Drehstab miteinander gekoppelt. Eine Drehmomentsensoreinheit 11 erfasst die Verdrehung der oberen Lenkwelle 3 gegenüber der unteren Lenkwelle 4 als ein Maß des an der Lenkwelle 3 oder des Lenkrades 2 manuell ausgeübten Drehmomentes. In Abhängigkeit des von der Drehmomentsensoreinheit 11 gemessen Drehmoments berechnet eine Steuereinheit 12 die Lenkunterstützung, die von der Servoeinheit 10 für den Fahrer bereitgestellt wird. Die Steuereinheit 12 ist redundant ausgelegt. Die Servoeinheit kann dabei als Hilfskraftunterstützungseinrichtung, entweder mit einer Lenkwelle, dem Lenkritzel oder der Zahnstange gekoppelt sein. Die jeweilige Hilfskraftunterstützung trägt ein Hilfskraftmoment in die Lenkwelle, das Lenkritzel und/oder in die Zahnstange ein, wodurch der Fahrer bei der Lenkarbeit unterstützt wird. Die in Figur 1 gezeigt Servoeinheit 10 wirkt über einen Riementrieb 13 auf einen Kugelgewindetrieb 14, dessen Gewindespindel auf der Zahnstange 6 ausgebildet ist.

Die redundant ausgelegte Steuereinheit 12 ist schematisch in Figur 2 dargestellt. Die Steuereinheit 12 weist zwei Steuerpfade 150,160 auf, die jeweils einen Inverter 151,161 umfassen, der dazu eingerichtet ist, die Spannungssignale in Phasenströme zur Ansteuerung der Motorphasen umzurechnen. Der Elektromotor 9 kann über beide Steuerpfade 150,160 jeweils, getrennt voneinander, angesteuert werden. Es kann aber auch vorgesehen sein, dass der Elektromotor 9 mehrere Spulensätze beinhaltet oder aus mehreren getrennten Motoren besteht, deren Drehachsen mechanisch gekoppelt sind. In diesen Fällen ist jeweils ein Steuerpfad zur Ansteuerung eines Spulensatzes bzw. eines Motors vorgesehen. Der in den beiden Steuerpfade 150,160 fließende Strom wird getrennt für jeden der beiden Steuerpfade in Signalrichtung vor dem entsprechenden Inverter 151,161 gemessen, bevorzugt mittels eines Stromsensors 152,162. Die Werte der beiden Strommessungen fließen in eine Unsymmetrieerkennungseinrichtung 17 ein, die dazu eingerichtet ist, eine Stromunsymmetrie zwischen den beiden Steuerpfaden 150,160 zu detektieren. Die Unsymmetrieerkennungseinrichtung 17 weist bevorzugt einen Operationsverstärker auf. Der Stromverbrauch beider Steuerpfade 150,160 ist im Normalfall gleich. Kommt es zu einem Kurzschluss der Batterie gegen Masse in einem der Steuerpfade 150,160, wird in einem ersten Moment der Strom durch vorhandene Zwischenkreiskondensatoren zurückgeführt, so dass das Signal des fehlerhaften Steuerpfades 150,160 eine entgegengesetzte Richtung zum Signal des fehlerfreien Steuerpfades 150,160 aufweist. Das vorliegende Ungleichgewicht zwischen den beiden Stromverbräuchen in den beiden Steuerpfaden 150,160 wird in der Unsymmetrieerkennungseinrichtung 17 detektiert. Überschreitet der Differenzwert einen vordefinierten Grenzwert, wird der fehlerhafte Steuerpfad 150,160 von der Batterie isoliert und der fehlerfreie Steuerpfad 150,160 übernimmt die Ansteuerung des Elektromotors 9. Vorzugsweise weist die Unsymmetrieerkennungseinrichtung 17 für jeden Steuerpfad 150,160 einen, hier nicht dargestellten, selbsthaltenden Komparator, der das Signal mit einer voreingestellten Referenzspannung vergleicht und auf Grundlage dieses Spannungsvergleichs ein Ausgangssignal erzeugt. Bevorzugt ist dem Komparator ein Differenzverstärker vorgeschaltet. Im fehlerhaften Steuerpfad bewirkt das Ausgangssignal ein Abschalten des Steuerpfades. In jedem Steuerpfad 150,160 sind in Signalrichtung vor und hinter dem Inverter 151,161 Schaltelemente 153,154,163,164 vorgesehen, die von dem Komparator zur Unterbrechung des Steuerpfades 150,160 angesprochen werden können. Die Schaltelemente 153, 163 trennen die Batterie, damit die Versorgungsspannung nicht einfällt. Die Schaltelemente 154, 164 trennen den Motor, so dass der Fehler kein Bremsmoment verursacht.

Die Schaltelemente 153,154,163,164 sind bevorzugt FET, insbesondere MOSFET.

Ein Kurzschluss in einem der Steuerpfade 150,160 kann zu einer transienten Überspannung in dem anderen, fehlerfreien Steuerpfad 150,160 führen. Die Transienten können ein Abschalten des fehlerfreien Steuerpfades 150,160 bewirken, da es nicht auszuschließen ist, dass die Überspannung in der Unsymmetrieerkennungseinrichtung 17 als Kurzschluss detektiert wird. Um ein solches unerwünschtes Ereignis zu verhindern, ist eine hier nicht dargestellte Schaltung zur gegenseitigen Abschaltung der Komparatoren vorgesehen. Kommt es zu einem Kurzschluss in einem der Steuerpfade 150,160 und wird dieser detektiert, wird der Komparator des fehlerfreien Steuerpfades 150,160 für einen kurzen Zeitraum deaktiviert. So kann verhindert werden, dass eine transiente Überspannung in dem fehlerfreien Steuerpfad 150,160 als Kurzschluss interpretiert wird.

Bevorzugt ist vorgesehen, dass beide Steuerpfade 150,160 eine eigene Stromversorgung aufweisen, d. h. die Stromversorgung ist ebenfalls redundant ausgelegt.

Beide Steuerpfade 150,160 haben bevorzugt eine hier nicht dargestellte Schnittstelle zur Motorkontrolleinheit (MCU), die die Durchführung von Motortests, das Zurücksetzen von Motorsollwerten, das Ein-und Ausschalten des Motors, und Zurücklesen von Motoristwerten ermöglicht.

## Patentansprüche

1. Kraftfahrzeuglenkung umfassend einen Elektromotor (9) und eine Steuereinheit (12), die den Elektromotor (9) ansteuert, wobei die Steuereinheit (12) mindestens zwei redundante Steuerpfade (150,160) zur Ansteuerung des Elektromotors und eine Unsymmetrieerkennungseinrichtung (17) aufweist, wobei die Unsymmetrieerkennungseinrichtung (17) dazu eingerichtet ist, die elektrischen Stromstärken beider Steuerpfade (150,160) zu vergleichen und bei Vorliegen einer Unsymmetrie eine Auftrennung des fehlerhaften Steuerpfades zu bewirken, **dadurch gekennzeichnet, dass** die Unsymmetrieerkennungseinrichtung (17) für jeden Steuerpfad (150,160) einen selbsthaltenden Komparator aufweist, der dazu eingerichtet ist, ein Signal des jeweiligen Steuerpfades mit einer voreingestellten Referenzspannung zu vergleichen und auf Grundlage dieses Spannungsvergleichs ein Ausgangssignal zu erzeugen, durch das die Auftrennung des fehlerhaften Steuerpfades bewirkt wird, und dass die Unsymmetrieerkennungseinrichtung (17) eine Schaltung zur gegenseitigen Abschaltung der Komparatoren aufweist, die ausgebildet ist, im Fall eines detektierten Kurzschlusses in einem der Steuerpfade (150,160) den Komparator des fehlerfreien Steuerpfades für einen kurzen Zeitraum zu deaktivieren.

2. Kraftfahrzeuglenkung nach Anspruch 1, **dadurch gekennzeichnet, dass** jeder Steuerpfad (150,160) wenigstens ein Schaltelement (153,154, 163,164) aufweist, das mit der Unsymmetrieerkennungseinrichtung (17) zur Auftrennung der Steuerpfade (150,160) verbunden ist.

3. Kraftfahrzeuglenkung nach Anspruch 1 oder 2, **dadurch gekennzeichnet, dass** jeder Steuerpfad (150,160) eine Strommessvorrichtung (152,162) aufweist, die die elektrische Stromstärke misst.

4. Kraftfahrzeuglenkung nach Anspruch 3, **dadurch gekennzeichnet, dass** jeder Steuerpfad (150,160) einen Inverter (151) umfasst, wobei die Strommessvorrichtung (152) in Signalrichtung vor dem Inverter (151) angeordnet ist.

5. Kraftfahrzeuglenkung nach einem der vorhergehenden Ansprüche, **dadurch gekennzeichnet, dass** jeder Steuerpfad (150,160) eine eigene Stromquelle aufweist.

6. Kraftfahrzeuglenkung nach einem der vorhergehenden Ansprüche, **dadurch gekennzeichnet, dass** jeder Steuerpfad (150,160) eine eigene Schnittstelle zu einer Motorkontrolleinheit des Elektromotors (9) aufweist.

7. Kraftfahrzeuglenkung nach einem der vorhergehenden Ansprüche, **dadurch gekennzeichnet, dass** die Unsymmetrieerkennungseinrichtung (17) einen Operationsverstärker aufweist.

8. Kraftfahrzeuglenkung nach einem der vorhergehenden Ansprüche, **dadurch gekennzeichnet, dass** die Kraftfahrzeuglenkung eine elektromechanische Kraftfahrzeugservolenkung ist, umfassend eine mit einem Lenkmittel (2) verbundene obere Lenkwelle (3) und eine mit der oberen Lenkwelle (3) über einen Drehstab verbundene untere Lenkwelle (4), eine Drehmomentsensoreinheit (11), die ein von dem Fahrer in die obere Lenkwelle (3) eingeleitetes Drehmoment einer Lenkbewegung erfasst, den Elektromotor (9) zur Unterstützung der Lenkbewegung, und die Steuereinheit (12), die dazu eingerichtet ist, in Abhängigkeit von dem gemessenen Drehmoment den Elektromotor (9) anzusteuern.

9. Kraftfahrzeuglenkung nach einem der vorhergehenden Ansprüche 1 bis 7, **dadurch gekennzeichnet, dass** die Kraftfahrzeuglenkung eine Steer-by-Wire-Lenkung ist, umfassend einen auf die gelenkten Räder wirkenden, in Abhängigkeit von einem Fahrerlenkwunsch elektronisch geregelten Lenksteller, der mittels eines Lenkgetriebes auf die gelenkten Räder wirkt, und einen Rückwirkungen der Straße auf ein Lenkrad übertragenden Feedback-Aktuator aufweisend den Elektromotor (9) und die Steuereinheit (12).

10. Verfahren zur Ansteuerung eines Elektromotors (9) einer Kraftfahrzeuglenkung aufweisend eine Steuereinheit (12) umfassend mindestens zwei redundanten Steuerpfade (150,160) und eine Unsymmetrieerkennungseinrichtung (17), wobei jeder Steuerpfad (150,160) wenigstens ein Schaltelement (153,154,163,164) und eine Strommessvorrichtung (152,162) aufweist, und wobei folgende Verfahrensschritte vorgesehen sind:
• Messen der jeweiligen elektrischen Stromstärke in den beiden Strommessvorrichtungen (152,162),
• Vergleichen der gemessenen elektrischen Stromstärken mittels der Unsymmetrieerkennungseinrichtung (17),
• falls der Differenzwert der beiden elektrischen Stromstärken einen vorgegeben Grenzwert überschreitet, Auftrennen der Stromversorgung des fehlerhaften Steuerpfades (150,160) mittels des wenigstens einen Schaltelementes (153,154,163,164), wobei die Unsymmetrieerkennungseinrichtung (17) für jeden Steuerpfad (150,160) einen selbsthaltenden Komparator aufweist, wobei der Komparator ein Signal des jeweiligen Steuerpfades mit einer voreingestellten Referenzspannung vergleicht und auf Grundlage dieses Spannungsvergleichs ein Ausgangssignal erzeugt, mit dem das wenigstens eine Schaltelement (153,154,163,164) zur Auftrennung der Stromversorgung angesprochen wird,
• bei Vorliegen eines fehlerhaften Steuerpfades (150,160) Deaktivieren des Komparators des fehlerfreien Steuerpfades (150,160) für einen kurzen Zeitraum,
• Ansteuern des Elektromotors (9) mittels des fehlerfreien Steuerpfades (150,160).

11. Verfahren nach Anspruch 10, **dadurch gekennzeichnet, dass** jeder Steuerpfad (150,160) einen Inverter (151,161) umfasst, wobei das Strommessgerät (152,162) in Signalrichtung vor dem Inverter (151,161) angeordnet ist.

12. Verfahren nach Anspruch 10 oder 11, **dadurch gekennzeichnet, dass** jeder Steuerpfad (150,160) eine eigene Stromquelle aufweist.

13. Verfahren nach einem der vorhergehenden Ansprüche 10 bis 12, **dadurch gekennzeichnet, dass** jeder Steuerpfad (150,160) eine eigene Schnittstelle zu einer Motorkontrolleinheit des Elektromotors (9) aufweist.

14. Verfahren nach einem der vorhergehenden Ansprüche 10 bis 13, **dadurch gekennzeichnet, dass** die Unsymmetrieerkennungseinrichtung (17) einen Operationsverstärker aufweist.

## Claims

1. A motor vehicle steering system comprising an electric motor (9) and a control unit (12) which controls the electric motor (9), wherein the control unit (12) has at least two redundant control paths (150, 160) for controlling the electric motor and an asymmetry detection device (17), wherein the asymmetry detection device (17) is configured to compare the electric current intensities of the two control paths (150, 160) and to cause the faulty control path to be interrupted when there is asymmetry, **characterized in that** the asymmetry detection device (17) has, for each control path (150, 160), a latching comparator which is configured to compare a signal of the respective control path (150, 160) with a pre-set reference voltage and to generate an output signal on the basis of this voltage comparison, and that the asymmetry detection device (17) has a circuitry for mutually switching off the comparators, which is designed to deactivate the comparator of the fault-free control path for a short period of time if a short circuit is detected in one of the control paths (150, 160).

2. The motor vehicle steering system as claimed in claim 1, **characterized in that** each control path (150, 160) has at least one switching element (153, 154, 163, 164) which is connected to the asymmetry detection device (17) for interrupting the control paths (150, 160).

3. The motor vehicle steering system as claimed in claim 1 or 2, **characterized in that** each control path (150, 160) has a current measuring device (152, 162) which measures the electric current intensity.

4. The motor vehicle steering system as claimed in claim 3, **characterized in that** each control path (150, 160) comprises an inverter (151), wherein the current measuring device (152) is arranged upstream of the inverter (151) in the direction of the signals.

5. The motor vehicle steering system as claimed in one of the preceding claims, **characterized in that** each control path (150, 160) has a separate power source.

6. The motor vehicle steering system as claimed in one of the preceding claims, **characterized in that** each control path (150, 160) has a separate interface to a motor control unit of the electric motor (9).

7. The motor vehicle steering system as claimed in one of the preceding claims, **characterized in that** the asymmetry detection device (17) has an operational amplifier.

8. The motor vehicle steering system as claimed in one of the preceding claims, **characterized in that** the motor vehicle steering system is an electromechanical motor vehicle power steering system, comprising an upper steering shaft (3), which is connected to a steering means (2), and a lower steering shaft (4), which is connected to the upper steering shaft (3) via a torsion bar, a torque sensor unit (11), which senses a torque of a steering movement, said torque being introduced into the upper steering shaft (3) by the driver, the electric motor (9) for assisting the steering movement, and the control unit (12) which is configured to control the electric motor (9) as a function of the measured torque.

9. The motor vehicle steering system as claimed in one of the preceding claims 1 to 7, **characterized in that** the motor vehicle steering system is a steer-by-wire steering system, comprising a steering actuator which acts on the steered wheels, is controlled electronically as a function of a driver's steering request and acts on the steered wheels by means of a steering gear, and a feedback actuator which transmits reactions of the road to a steering wheel and has the electric motor (9) and the control unit (12).

10. A method for controlling an electric motor (9) of a motor vehicle steering system having a control unit (12) comprising at least two redundant control paths (150, 160) and an asymmetry detection device (17), wherein each control path (150, 160) has at least one switching element (153, 154, 163, 164) and a current measuring device (152, 162), and wherein the following method steps are provided:
• measuring the respective electric current intensity in the two current measuring devices (152, 162),
• comparing the measured electric current intensities by means of the asymmetry detection device (17),
• if the difference value of the two electrical intensities exceeds a predefined limiting value, interrupting the power supply of the faulty control path (150, 160) by means of the at least one switching element (153, 154, 163, 164), wherein the asymmetry detection device (17) has a latching comparator for each control path (150, 160), wherein the comparator compares a signal of the respective control path with a pre-set reference voltage and generates an output signal on the basis of this voltage comparison, said output signal is being used for activating the at least one switching element (153, 154, 163, 164) for disconnecting the power supply,
• if a faulty control path (150, 160) exists, the comparator of the fault free control path (150, 160) is deactivated for a brief period of time,
• controlling the electric motor (9) by means of the fault free control path (150, 160).

11. The method as claimed in claim 10, **characterized in that** each control path (150, 160) comprises an inverter (151, 161), wherein the current measuring device (152, 162) is arranged upstream of the inverter (151, 161) in the direction of signals.

12. The method as claimed in claim 10 or 11, **characterized in that** each control path (150, 160) has a separate power source.

13. The method as claimed in one of the preceding claims 10 to 12, **characterized in that** each control path (150, 160) has a separate interface to a motor control unit of the electric motor (9).

14. The method as claimed in one of the preceding claims 10 to 13, **characterized in that** the asymmetry detection device (17) has an operational amplifier.

## Revendications

1. Système de direction de véhicule automobile comprenant un moteur électrique (9) et une unité de commande (12) qui commande le moteur électrique (9), dans lequel l'unité de commande (12) a au moins deux voies de commande (150, 160) redondantes pour commander le moteur électrique et un dispositif de détection d'asymétrie (17), dans lequel le dispositif de détection d'asymétrie (17) est configuré pour comparer les intensités de courant électrique des deux voies de commande (150, 160) et pour provoquer l'interruption de la voie de commande défectueuse lorsqu'il y a asymétrie, **caractérisé en ce que** le dispositif de détection d'asymétrie (17) a, pour chaque voie de commande (150, 160), un comparateur à verrouillage configuré pour comparer un signal de la voie de commande (150, 160) respective à une tension de référence prédéfinie et pour générer un signal de sortie sur la base de cette comparaison de tension, et que le dispositif de détection d'asymétrie (17) comporte un circuit de désactivation mutuelle des comparateurs, conçu pour désactiver le comparateur de la voie de commande exempte de défaut pendant une courte période si un court-circuit est détecté dans l'une des voies de commande (150, 160).

2. Le système de direction de véhicule automobile selon la revendication 1, **caractérisé par le fait que** chaque voie de commande (150, 160) comporte au moins un élément de commutation (153, 154, 163, 164) qui est relié au dispositif de détection d'asymétrie (17) pour interrompre les voies de commande (150, 160).

3. Le système de direction du véhicule automobile selon la revendication 1 ou 2, **caractérisé par le fait que** chaque voie de commande (150, 160) possède un dispositif de mesure du courant (152, 162) qui mesure l'intensité du courant électrique.

4. Le système de direction de véhicule automobile selon la revendication 3, **caractérisé par le fait que** chaque voie de commande (150, 160) comprend un onduleur (151), dans lequel le dispositif de mesure du courant (152) est placé en amont de l'onduleur (151) dans la direction des signaux.

5. Le système de direction de véhicule automobile selon l'une des revendications précédentes, **caractérisé par le fait que** chaque voie de commande (150, 160) a une source d'énergie séparée.

6. Le système de direction de véhicule automobile selon l'une des revendications précédentes, **caractérisé par le fait que** chaque voie de commande (150, 160) a une interface séparée avec une unité de commande du moteur électrique (9).

7. Le système de direction de véhicule automobile selon l'une des revendications précédentes, **caractérisé par le fait que** le dispositif de détection d'asymétrie (17) est un amplificateur opérationnel.

8. Le système de direction de véhicule automobile selon l'une des revendications précédentes, **caractérisé en ce que** le système de direction de véhicule automobile est un système de direction assistée électromécanique de véhicule automobile, comprenant un arbre de direction supérieur (3), qui est relié à un moyen de direction (2), et un arbre de direction inférieur (4), qui est relié à l'arbre de direction supérieur (3) par l'intermédiaire d'une barre de torsion, un capteur de couple (11), qui détecte le couple d'un mouvement de direction, ledit couple étant introduit dans l'arbre de direction supérieur (3) par le conducteur, le moteur électrique (9) pour assister le mouvement de direction, et l'unité de commande (12) qui est configurée pour commander le moteur électrique (9) en fonction du couple mesuré.

9. Le système de direction du véhicule automobile selon l'une des revendications précédentes 1 à 7, **caractérisé en ce que** le système de direction du véhicule automobile est un système de direction par fil, comprenant un actionneur de direction qui agit sur les roues directrices, est commandé électroniquement en fonction de la demande de direction du conducteur et agit sur les roues directrices au moyen d'un mécanisme de direction, et un actionneur de rétroaction qui transmet les réactions de la route à un volant de direction et possède le moteur électrique (9) et l'unité de commande (12).

10. Procédé de commande d'un moteur électrique (9) d'un système de direction de véhicule automobile comportant une unité de commande (12) comprenant au moins deux voies de commande (150, 160) redondantes et un dispositif de détection d'asymétrie (17), dans lequel chaque voie de commande (150, 160) comporte au moins un élément de commutation (153, 154, 163, 164) et un dispositif de mesure du courant (152, 162), et dans lequel les étapes suivantes du procédé sont prévues :
• mesurer l'intensité respective du courant électrique dans les deux dispositifs de mesure du courant (152, 162),
• comparer les intensités de courant électrique mesurées au moyen du dispositif de détection de l'asymétrie (17),
• si la différence entre les deux intensités électriques dépasse une valeur limite prédéfinie, interrompre l'alimentation électrique de la voie de commande (150, 160) défectueuse au moyen d'au moins un élément de commutation (153, 154, 163, 164), dans lequel le dispositif de détection d'asymétrie (17) comporte un comparateur à verrouillage pour chaque voie de commande (150, 160), dans lequel le comparateur compare un signal de la voie de commande respective avec une tension de référence prédéfinie et génère un signal de sortie sur la base de cette comparaison de tension, ledit signal de sortie étant utilisé pour activer au moins un élément de commutation (153, 154, 163, 164) afin de déconnecter l'alimentation électrique,
• s'il existe une voie de commande (150, 160) défectueuse, le comparateur de la voie de commande (150, 160) sans défaut est désactivé pendant un bref laps de temps,
• commander le moteur électrique (9) au moyen de la voie de commande (150, 160) sans défaut.

11. Le procédé selon la revendication 10, **caractérisé par le fait que** chaque voie de commande (150, 160) comprend un onduleur (151, 161), dans lequel le dispositif de mesure du courant (152, 162) est placé en amont de l'onduleur (151, 161) dans la direction des signaux.

12. Le procédé selon la revendication 10 ou 11, **caractérisée par le fait que** chaque voie de commande (150, 160) dispose d'une source d'énergie distincte.

13. Le procédé selon l'une des revendications précédentes 10 à 12, **caractérisé par le fait que** chaque voie de commande (150, 160) a une interface séparée avec une unité de commande du moteur électrique (9).

14. Le procédé selon l'une des revendications précédentes 10 à 13, **caractérisé par le fait que** le dispositif de détection d'asymétrie (17) est un amplificateur opérationnel.
